# FASCICULE DE BREVET EUROPEEN

(11) **EP 3 182 220 B1**
(45) Date de publication et mention de la délivrance du brevet: **12.12.2018**
(21) Numéro de dépôt: 16194408.7
(22) Date de dépôt: 18.10.2016
(51) Int. Cl.: G04B 47/00, G04B 47/06, G04G 21/00, G04G 21/02, A44C 5/00

(54) **BRACELET ÉLECTRONIQUE POUR BOITE DE MONTRE**
ELEKTRONISCHES ARMBAND FÜR UHRENGEHÄUSE
ELECTRONIC STRAP FOR WATCH CASE

(43) Date de publication de la demande: 21.06.2017
(73) Titulaire: The Swatch Group Research and Development Ltd, 2074 Marin (CH)
(72) Inventeur: Fostinis, Dimitri, 2740 Moutier (CH); Nicolas, Cédric, 2000 Neuchâtel (CH); Tortora, Pierpasquale, 2000 Neuchâtel (CH)
(74) Mandataire: Goulette, Ludivine

(56) Documents cités:
- WO-A1-2010/146162
- WO-A1-2015/107523
- US-A- 4 417 819
- US-A1- 2008 004 510
- US-A1- 2015 323 788
- David Szondy: "Kairos TBand turns almost any watch into a smartwatch", , 24 novembre 2014 (2014-11-24), pages 1-3, XP055262033, Extrait de l'Internet: URL:http://www.gizmag.com/kairos-tband/348 11/ [extrait le 2016-04-01]

## Description

### Domaine de l'invention

La présente invention concerne un bracelet électronique apte à être attaché à une boîte de montre. On appelle bracelet électronique un bracelet comprenant un circuit imprimé flexible surmoulé portant des composants électroniques permettant de réaliser des fonctions, par exemple mesurer la pression environnante lorsque le bracelet est porté pendant une plongée sous-marine. On dit que le bracelet électronique est connecté lorsqu'en plus il est capable de communiquer avec un dispositif électronique tel qu'un smartphone, par exemple pour transmettre au dispositif électronique les valeurs de pression.

### Arrière-plan de l'invention

Pour permettre aux montres mécaniques de réaliser des fonctions de montre électronique, voire de montre connectée, tout en évitant d'intégrer des composants électroniques au sein des boitiers de montre, il a été conçu des bracelets électroniques dotés de moyens de fixation à un boitier de montre mécanique. Tous les composants électroniques sont intégrés au bracelet, lui offrant de nombreuses fonctionnalités telles que monitorer l'activité physique du porteur du bracelet, informer le porteur d'un appel ou message entrant sur un smartphone couplé au bracelet, commander à distance un dispositif électronique, etc.

Dans cette optique, il importe de pouvoir notifier au porteur du bracelet toute sorte d'événement ou d'état relatif à l'activité du bracelet et/ou du dispositif électronique auquel le bracelet est couplé. Un évènement ou un état relatif à l'activité du bracelet et/ou du dispositif électronique auquel le bracelet est couplé est par exemple mais non limitativement : l'activation ou la désactivation d'une fonction du bracelet, le déroulement d'une fonction par le bracelet (par exemple des prises de mesures par des capteurs du bracelet), l'établissement ou l'achèvement d'un transfert de données entre le bracelet et le dispositif électronique, le déroulement d'un transfert de données entre le bracelet et le dispositif électronique, la réception d'un appel ou d'un message par le dispositif électronique, etc.

WO 2015/107523 et XP055262033 divulguent des bracelets électroniques.

US 2008/004510 divulgue un dispositif électronique portable comprenant un émetteur d'ondes lumineuses dans son boîtier et un guide d'ondes pour guider les ondes lumineuses vers un indicateur dans son bracelet.

US 2015/0323788 divulgue un bracelet électronique pour pièce d'horlogerie, comprenant une feuille de circuit imprimé, un insert disposé sur la feuille de circuit imprimé, comprenant un élément de guidage comprenant un guide d'ondes lumineuses comportant :
- une entrée disposée à une interface entre l'élément de guidage et la feuille de circuit imprimé,
- une première sortie disposée de sorte à faire face à une première zone de la boite de montre,
- une première portion reliant l'entrée à la première sortie,
et un émetteur d'ondes lumineuses installé sur la feuille de circuit imprimé, au niveau de l'entrée du guide d'ondes.

### Résumé de l'invention

Le but de la présente invention est de répondre au besoin cité précédemment.

A cet effet, l'invention se rapporte à un bracelet électronique pour pièce d'horlogerie, comprenant :
- une feuille de circuit imprimé
- un insert disposé sur la feuille de circuit imprimé, comprenant un élément de guidage agencé pour être placé entre et fixé à une paire de cornes d'une boite de montre, l'élément de guidage comprenant un guide d'ondes lumineuses comportant :
   - une entrée disposée à une interface entre l'élément de guidage et la feuille de circuit imprimé
   - une première sortie disposée de sorte à faire face à une première zone de la boite de montre comprise entre les deux cornes lorsque l'élément de guidage est placé entre et fixé à la paire de cornes
   - une première portion reliant l'entrée à la première sortie
- un émetteur d'ondes lumineuses installé sur la feuille de circuit imprimé, au niveau de l'entrée du guide d'ondes

Ainsi, lorsque l'émetteur d'ondes lumineuses émet une onde lumineuse, l'onde lumineuse pénètre dans le guide d'ondes lumineuses via l'entrée disposée à l'interface entre l'élément de guidage et la partie médiane, se propage jusqu'à la première sortie via la première portion, et est enfin dirigée au niveau de la première zone, où elle est réfléchie et par conséquent visible par le porteur du bracelet.

D'autres caractéristiques avantageuses du bracelet électronique selon l'invention, pouvant être prises isolément ou en combinaison, sont définies aux revendications 2 à 8.

L'invention concerne également une pièce d'horlogerie comprenant un bracelet selon l'invention, l'élément de guidage étant placé entre et fixé à une paire de cornes de la boite de montre.

D'autres caractéristiques avantageuses de la pièce d'horlogerie selon l'invention, pouvant être prises isolément ou en combinaison, sont définies aux revendications 10 à 12.

### Description sommaire des figures

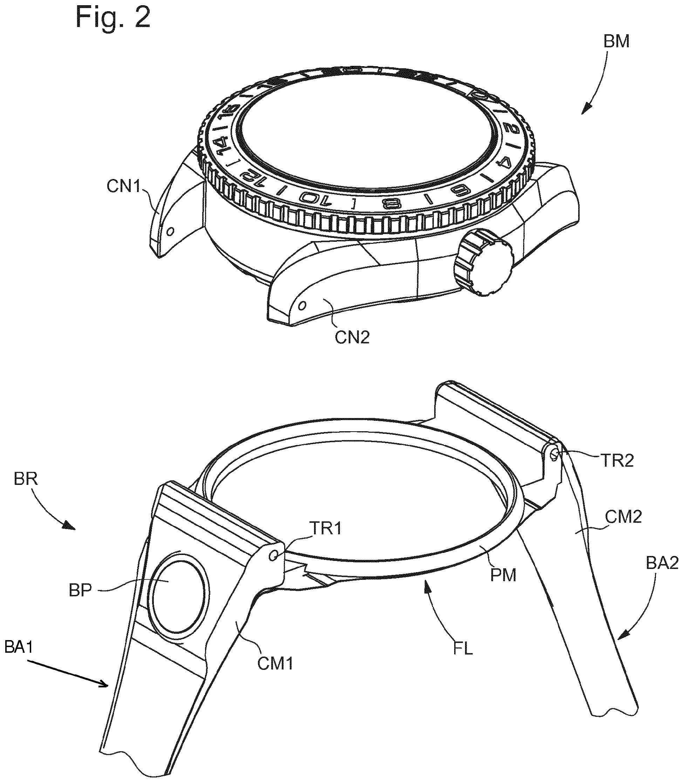

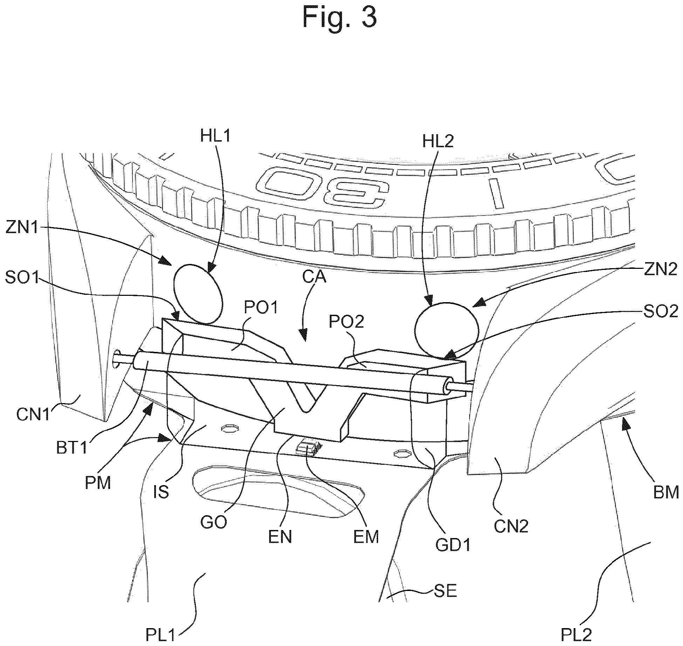

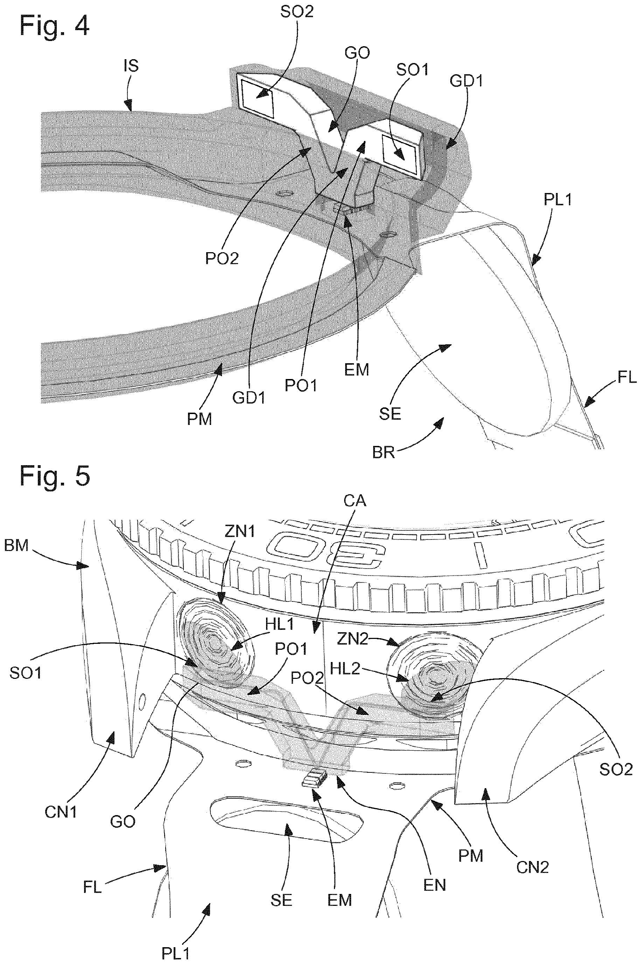

D'autres particularités et avantages ressortiront clairement de la description qui en est faite ci-après, à titre indicatif et nullement limitatif, en référence aux figures annexées montrant :

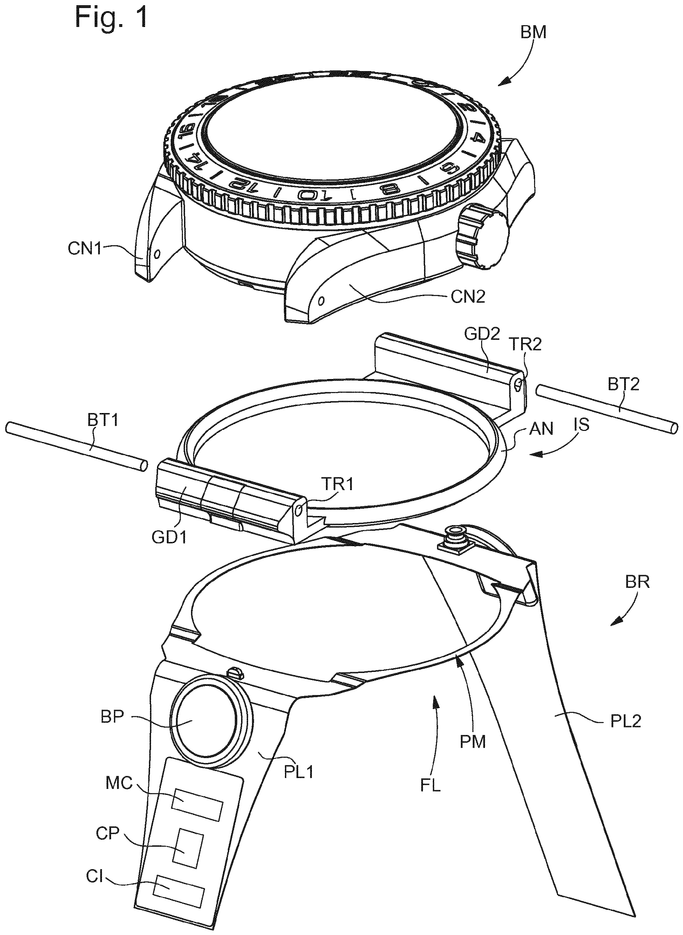

- À la figure 1, une vue en perspective à l'état dissocié de certains éléments d'une pièce d'horlogerie selon l'invention, dont une feuille de circuit imprimé, un insert, une boite de montre et deux barrettes.
- A la figure 2, une vue en perspective à l'état dissocié d'éléments de la figure 1 dont la feuille de circuit imprimé, l'insert et la boite de montre, une couche de surmoulage ayant été ajoutée à la feuille de circuit imprimé.
- A la figure 3, une vue en perspective d'éléments de la figure 1, dont la feuille de circuit imprimé, un élément de guidage de l'insert, la boite de montre et une barrette.
- A la figure 4, une vue en perspective d'éléments de la figure 3, dont un guide d'ondes lumineuses de l'élément de guidage et la feuille de circuit imprimé.
- A la figure 5, une vue en perspective d'une boite de montre dont la carrure a subi un traitement de surface, et le guide d'ondes lumineuses et la feuille de circuit imprimé de la figure 4.

### Description détaillée des modes de réalisation préférés

L'invention concerne une pièce d'horlogerie comportant un bracelet électronique fixé à une boite de montre via par exemple deux barrettes.

Sur la figure 1 est représenté un mode de réalisation préféré mais non limitatif d'éléments d'un bracelet électronique BR selon l'invention. Selon ce mode de réalisation préféré, le bracelet électronique BR est de type manchette : le bracelet BR comporte une feuille de circuit imprimé FL en un seul tenant formée d'une première portion latérale PL1, d'une partie médiane PM globalement annulaire prolongeant la première portion latérale PL1, et d'une deuxième portion latérale PL2 prolongeant la partie médiane PM. Chacune de ces portions latérales PL1, PL2 est un élément d'un des deux bras du bracelet : chaque bras de bracelet comporte donc une portion de circuit imprimé.

Dans des modes de réalisation alternatifs non représentés, le bracelet n'est pas de type manchette mais est au contraire formé de deux parties distinctes. Dans un premier de ces modes de réalisation alternatifs, la feuille de circuit imprimé est formée de deux portions distinctes. La feuille ne comprend en effet pas de partie médiane et n'est formée que des deux portions latérales PL1, PL2, qui sont déconnectées électriquement et mécaniquement. Chacune de ces portions latérales PL1, PL2 est un élément d'un des deux bras du bracelet : chaque bras de bracelet comporte donc une portion de circuit imprimé. Dans un deuxième de ces modes de réalisation alternatifs, la feuille de circuit imprimé ne comprend que la première portion latérale PL1. La première portion latérale PL1 est un élément de l'un des deux bras du bracelet ; le deuxième bras du bracelet ne comprend pas de circuit imprimé.

Le bracelet BR comporte également un ensemble de composants électriques et/ou électroniques montés sur la première portion latérale PL1 et éventuellement sur la deuxième portion latérale PL2 lorsque cette dernière existe. Les composants comportent par exemple un microcontrôleur MC, une source d'énergie électrique SE (visible à la figure 3 uniquement), et des moyens de communication CI avec un dispositif électronique par exemple via une interface sans fil de type Bluetooth, Wifi ou NFC, etc. Les composants peuvent aussi comprendre un ou plusieurs capteurs CP et/ou un ou plusieurs bouton-poussoirs BP.

Dans le mode de réalisation préféré et représenté à la figure 1, c'est-à-dire dans le cas du bracelet manchette, le bracelet BR comporte en outre un insert IS destiné à être disposé sur la partie médiane PM de la feuille de circuit imprimé FL. L'insert IS comporte un anneau rigide AN et deux éléments de guidage GD1, GD2 diamétralement opposés. Les éléments de guidage GD1, GD2 sont destinés à être disposés sur la partie médiane PM de la feuille de circuit imprimé, à la frontière avec les portions latérales PL1, PL2. La boite de montre BM est destinée à être disposée au-dessus dudit insert IS, chaque élément de guidage GD1, GD2 étant agencé pour se placer entre une paire de cornes CN1, CN2 de la boite de montre BM. Les éléments de guidage GD1, GD2 sont chacun percés d'un trou TR1, TR2 pour le passage des barrettes BT1, BT2, lesdites barrettes BT1, BT2 permettant de fixer les paires de cornes de la boite de montre à l'insert IS.

Comme cela est visible à la figure 2, le bracelet BR comporte également une couche de surmoulage CM1, CM2, par exemple en matériau plastique ou élastomère, ajoutée lorsque l'ensemble des composants a été monté sur les portions latérales PL1, PL2 de la feuille de circuit imprimé FL et que l'insert IS a été convenablement disposé sur la partie médiane PM de la feuille de circuit imprimé FL. La couche de surmoulage permet de protéger les composants portés par les portions latérales PL1, PL2 de la feuille de circuit imprimé FL et de solidariser l'insert IS et la feuille de circuit imprimé FL. Pour cela, la couche de surmoulage comporte deux portions CM1, CM2. Une première portion de surmoulage CM1 recouvre la première portion latérale PL1 de la feuille de circuit imprimé FL et l'un des éléments de guidage GD1 de l'insert IS afin de créer un premier bras BA1 de bracelet. Une deuxième portion de surmoulage CM2 recouvre la deuxième portion latérale PL2 de la feuille de circuit imprimé FL et l'autre des éléments de guidage GD2 de l'insert IS afin de créer un deuxième bras de bracelet BA2. Dans les premier et deuxième modes de réalisation alternatifs, le bracelet ne comporte pas la totalité de l'insert, mais seulement les éléments de guidage GD1, GD2, chacun faisant partie d'un des bras du bracelet. Dans le premier mode de réalisation alternatif, chaque élément de guidage GD1, GD2 est destiné à être disposé sur une partie extrémale des portions latérales PL1, PL2, puis à être placé entre une paire de cornes CN1, CN2 de la boite de montre BM. Les portions de surmoulage CM1, CM2 permettent entre autres de solidariser les portions latérales PL1, PL2 aux éléments de guidage GD1, GD2. Dans le deuxième mode de réalisation alternatif, le premier élément de guidage GD1 est destiné à être disposé sur une partie extrémale de la première portion latérale PL1, puis à être placé entre une paire de cornes CN1, CN2 de la boite de montre BM ; le deuxième élément de guidage GD2 est un élément du deuxième bras du bracelet permettant sa solidarisation avec l'autre paire de cornes de la boite de montre BM. La première portion de surmoulage CM1 permet entre autres de solidariser la première portion latérale PL1 au premier élément de guidage GD1.

Comme cela est visible aux figures 3 et 4, le bracelet BR selon l'invention est particulier en ce que le premier élément de guidage GD1 fixé ou destiné à être fixé à l'une des paires de cornes CN1, CN2 comporte un guide d'ondes lumineuses GO, et en ce que la feuille de circuit imprimé FL porte un émetteur EM d'ondes lumineuses connecté électriquement à l'ensemble de composants et disposé face à une entrée EN du guide d'ondes lumineuses GO. Dans un mode de réalisation préféré, le guide d'ondes GO est constitué de plastique, ou tout autre matériau transparent. On note que la localisation du guide d'onde GO dans le premier élément de guidage GD1 permet de le rendre discret pour ne pas affecter l'esthétisme de la pièce d'horlogerie.

Dans le mode de réalisation non limitatif de la figure 3, le guide d'ondes lumineuses GO comporte deux sorties SO1, S02 et deux portions P01, P02 pour relier l'entrée EN à chacune des sorties S01, S02. Toutefois, le guide d'ondes GO pourrait ne comprendre qu'une sortie et qu'une portion pour relier l'entrée à ladite sortie, ou plus de deux sorties et autant de portions que de sorties. Le guide d'ondes GO pourrait également comprendre plus d'une entrée : le guide comprendrait alors autant de portions que nécessaire pour relier chaque entrée à chaque sortie. Dans ce cas, la partie médiane PM porterait autant d'émetteurs d'ondes lumineuses que d'entrées, chaque émetteur devant être disposé face à une entrée du guide d'ondes lumineuses GO.

La première sortie S01 et la deuxième sortie S02 sont disposées de sorte à faire face à une portion de carrure CA de la boite de montre BA comprise entre les deux cornes CN1, CN2. Ainsi, une onde lumineuse émise par l'émetteur EM d'ondes lumineuses est guidée et dirigée vers la portion de carrure CA, où elle est visible par le porteur de la pièce d'horlogerie. L'onde lumineuse forme deux halos lumineux HL1, HL2 sur la portion de carrure CA, représentés sur la figure 3. Le premier halo lumineux HL1 est visible au niveau d'une première zone ZN1 de la portion de carrure CA, la première zone ZN1 faisant face à la première sortie S01 du guide d'ondes lumineuses GO. Le deuxième halo lumineux HL2 est visible au niveau d'une deuxième zone ZN2 de la portion de carrure CA, la deuxième zone ZN2 faisant face à la deuxième sortie S02 du guide d'ondes lumineuses GO.

Naturellement, dans le cas où le guide d'ondes GO ne comprendrait qu'une sortie, seul un halo lumineux serait visible. Un long halo lumineux allant d'une corne à l'autre serait envisageable, de même qu'un halo situé du côté d'une corne ou un halo situé sensiblement à égale distance des deux cornes. Dans le cas où le guide d'ondes comprendrait plus de deux sorties, autant de halo lumineux que de sorties seraient visibles. On note également que la forme du/des halo(s) dépend de la forme de la/des sorties.

On remarque que dans l'exemple représenté, la première sortie S01 est disposée du côté de la première corne CN1, tandis que la deuxième sortie S02 est disposée du côté de la deuxième corne CN2. Bien que cela ne soit pas indispensable, il est avantageux de placer les sorties S01, S02 du guide d'ondes lumineuses GO à proximité des cornes CN1 pour des boites de montre dont la portion de carrure CA est courbée. En effet, dans ce cas, l'espace entre la portion de carrure CA est minimal à égale distance entre les cornes CN1, CN2, et maximal à proximité des cornes CN1, CN2. Or placer une sortie du guide d'ondes lumineuses GO trop près de la portion de carrure CA pourrait dégrader la visibilité d'une onde lumineuse guidée par le guide d'ondes lumineuses, puisque le halo lumineux sur la portion de carrure CA pourrait être caché par l'élément de guidage EG1. Naturellement, ces considérations ne sont pas valables pour des boites de montre carrées ou rectangulaires, puisque le bracelet serait équidistant à la portion de carrure sur toute sa largeur.

Par ailleurs, pour obtenir des halos lumineux HL1, HL2 d'intensité similaire, il est avantageux de placer l'entrée EN du guide lumineux GO à distance sensiblement égale de la première sortie S01 et de la deuxième sortie S02. Le guide lumineux GO est alors globalement en forme de V. Toutefois, des configurations différentes du guide lumineux GO sont envisageables tant que l'encombrement du guide lumineux GO reste limité.

En outre, l'émetteur EM d'ondes lumineuses comporte au moins une source ponctuelle d'ondes lumineuses, par exemple une diode électroluminescente. Avantageusement, l'émetteur EM d'ondes lumineuses comporte plusieurs sources ponctuelles à proximité les unes des autres, les sources étant aptes à émettre des ondes lumineuses à des fréquences différentes, c'est-à-dire de couleurs différentes. Ainsi, les sources ponctuelles peuvent être soit éteintes soit allumées de sorte créer des halos lumineux d'une couleur particulière en fonction de l'information à fournir au porteur de la pièce d'horlogerie. Naturellement, la au moins une source ponctuelle peut également être allumée selon une séquence temporelle correspondant à une information à fournir au porteur de la pièce d'horlogerie.

Puisque l'émetteur EM d'ondes lumineuses est relié électriquement à l'ensemble de composants électriques et/ou électroniques, la au moins une source ponctuelle de l'émetteur EM d'ondes lumineuses peut être activée en fonction d'un d'événement ou d'un état relatif à l'activité du bracelet ou d'un dispositif électronique auquel le bracelet est couplé. Par exemple, la source ponctuelle peut être activée lorsque le bouton poussoir BP est pressé, lorsqu'un message est reçu par le dispositif électronique, ou encore lorsque des données sont transférées entre le bracelet BR et le dispositif électronique.

On note que pour modifier la réflexion de la lumière sur la portion de carrure CA et ainsi modifier les formes et/ou intensités lumineuses des halos HL1, HL2 vus par le porteur de la pièce d'horlogerie, on pourrait réaliser des traitements de surface des zones ZN1, ZN2. Un exemple de traitement de surface est montré à la figure 5. Dans cet exemple, des anneaux concentriques ont été réalisés par creusement au niveau des zones ZN1, ZN2, de sorte à réaliser un effet de lentille de Fresnel. Des micro-structurations par laser ou autres seraient également envisageables pour créer différents effets tels qu'une meilleure diffusion de la lumière, ou faire ressortir un motif, par exemple un logo. Un sablage (c'est-à-dire une projection sous pression de sable) des zones ZN1, ZN2 pourrait également être réalisé de sorte à rendre les zones ZN1, ZN2 irrégulières : les halos HL1, HL2 seraient moins lumineux mais plus étendus, et ainsi plus esthétiques.

Bien entendu, la présente invention ne se limite pas à l'exemple illustré mais est susceptible de diverses variantes et modifications qui apparaîtront à l'homme de l'art.

## Revendications

1. Bracelet électronique (BR) pour pièce d'horlogerie, comprenant :
- une feuille de circuit imprimé (FL)
- un insert (IS) disposé sur la feuille de circuit imprimé (FL), comprenant un élément de guidage (EG1) agencé pour être placé entre et fixé à une paire de cornes (CN1, CN2) d'une boite de montre (BM), l'élément de guidage (EG1) comprenant un guide d'ondes lumineuses (GO) comportant :
▪ une entrée (EN) disposée à une interface entre l'élément de guidage (GD1) et la feuille de circuit imprimé (FL)
▪ une première sortie (SO1) disposée de sorte à faire face à une première zone (ZN1) de la boite de montre (BM) comprise entre les deux cornes (CN1, CN2) lorsque l'élément de guidage (GD1) est placé entre et fixé à la paire de cornes (CN1, CN2)
▪ une première portion (P01) reliant l'entrée (EN) à la première sortie (SO1)
- un émetteur (EM) d'ondes lumineuses installé sur la feuille de circuit imprimé (FL), au niveau de l'entrée (EN) du guide d'ondes (GO).

2. Bracelet (BR) selon la revendication précédente, le guide d'ondes (GO) comprenant une deuxième sortie (S02) disposée de sorte à faire face à une deuxième zone (ZN2) de la boite de montre comprise entre les deux cornes (CN1, CN2) lorsque l'élément de guidage (GD1) est placé entre et fixé à la paire de corne (CN1, CN2), et comprenant une deuxième portion (P02) reliant l'entrée (EN) à la deuxième sortie (S02).

3. Bracelet (BR) selon la revendication précédente, la première sortie (SO1) et la deuxième sortie (S02) étant disposées de sorte que la première zone (ZN1) soit située du côté de l'une des cornes (CN1), et que la deuxième zone (ZN2) soit située du côté de l'autre des cornes (CN2).

4. Bracelet (BR) selon l'une des revendications précédentes, l'émetteur (EM) d'ondes lumineuses comprenant au moins deux sources d'ondes de fréquences différentes.

5. Bracelet (BR) selon l'une des revendications précédentes, le guide d'ondes lumineuses (GO) étant transparent.

6. Bracelet (BR) selon l'une des revendications précédentes, la feuille de circuit imprimé (FL) comprenant une première portion latérale (PL1) et un ensemble de composants dont une source d'énergie (SE) et un microcontrôleur (MC), l'ensemble de composants étant monté sur la première portion latérale (PL1), l'émetteur d'ondes lumineuses (EM) étant connecté électriquement à l'ensemble de composants.

7. Bracelet (BR) selon la revendication précédente, l'ensemble de composants comportant au moins un bouton poussoir (BP).

8. Bracelet (BR) selon l'une des revendications précédentes, l'ensemble de composants comprenant des moyens de communication à un autre objet électronique via un système de communications sans fil du type Bluetooth, WiFi ou NFC.

9. Pièce d'horlogerie comprenant un bracelet (BR) selon l'une des revendications précédentes et une boite de montre (BM), l'élément de guidage (GD1) étant placé entre et fixé à une paire de cornes (CN1, CN2) de la boite de montre (BM).

10. Pièce d'horlogerie selon la revendication précédente, la première zone (ZN1) présentant une surface irrégulière.

11. Pièce d'horlogerie selon la revendication précédente, la première zone (ZN1) étant sablée ou structurée.

12. Pièce d'horlogerie selon la revendication 9, la première zone (ZN1) présentant un aspect de lentille de Fresnel.

## Patentansprüche

1. Elektronisches Armband (BR) für Zeitmessgeräte, umfassend:
- eine gedruckte Leiterplatte (FL),
- einen auf der gedruckten Leiterplatte (FL) angeordneten Einsatz (IS), umfassend ein Führungselement (EG1), angeordnet zwischen und befestigt an einem Paar Hörner (CN1, CN2) eines Uhrengehäuses (BM), wobei das Führungselement (EG1) einen Lichtwellenleiter (GO) aufweist, umfassend:
• einen Eingang (EN), der an einer Schnittstelle zwischen dem Führungselement (GD1) und der gedruckten Leiterplatte (FL) angeordnet ist,
• einen ersten Ausgang (SO1), der so angeordnet ist, dass er einer ersten Zone (ZN1) des Uhrengehäuses (BM) zwischen den beiden Hörnern (CN1, CN2) zugewandt ist, wenn das Führungselement (GD1) zwischen dem Paar Hörner (CN1, CN2) angeordnet und an ihm befestigt ist, und
• einen ersten Abschnitt (PO1), der den Eingang (EN) mit dem ersten Ausgang (SO1) verbindet, und
- einen Lichtwellensender (EM), der auf der gedruckten Leiterplatte (FL) auf Höhe des Eingangs (EN) des Wellenleiters (GO) installiert ist.

2. Armband (BR) nach dem vorhergehenden Anspruch, wobei der Wellenleiter (GO) einen zweiten Ausgang (SO2) aufweist, der so angeordnet ist, dass er einer zweiten Zone (ZN2) des Uhrengehäuses zwischen den beiden Hörnern (CN1, CN2) zugewandt ist, wenn das Führungselement (EG1) zwischen dem Paar Hörner (CN1, CN2) angeordnet und an ihm befestigt ist, und einen zweiten Abschnitt (PO2) aufweist, der den Eingang (EN) mit dem zweiten Ausgang (SO2) verbindet.

3. Armband (BR) nach dem vorhergehenden Anspruch, wobei der erste Ausgang (SO1) und der zweite Ausgang (SO2) in der Weise angeordnet sind, dass sich die erste Zone (ZN1) auf Seiten eines der Hörner (CN1) befindet und dass sich die zweite Zone (ZN2) auf Seiten des anderen der Hörner (CN2) befindet.

4. Armband (BR) nach einem der vorhergehenden Ansprüche, wobei der Lichtwellensender (EM) wenigstens zwei Lichtwellenquellen mit unterschiedlichen Frequenzen umfasst.

5. Armband (BR) nach einem der vorhergehenden Ansprüche, wobei der Lichtwellenleiter (GO) transparent ist.

6. Armband (BR) nach einem der vorhergehenden Ansprüche, wobei die gedruckte Leiterplatte (FL) einen ersten Seitenabschnitt (PL1) und einen Satz von Komponenten mit einer Energiequelle (SE) und einem Mikrocontroller (MC) umfasst, wobei der Satz von Komponenten auf dem ersten Seitenabschnitt (PL1) montiert ist und wobei der Lichtwellensender (EM) mit dem Satz von Komponenten elektrisch verbunden ist.

7. Armband (BR) nach dem vorhergehenden Anspruch, wobei der Satz von Komponenten wenigstens einen Druckknopf (BP) umfasst.

8. Armband (BR) nach einem der vorhergehenden Ansprüche, wobei der Satz von Komponenten Mittel für die Kommunikation zu einem anderen elektronischen Objekt über ein drahtloses Kommunikationssystem wie Bluetooth, WiFi oder NFC umfasst.

9. Zeitmessgerät, umfassend ein Armband (BR) nach einem der vorhergehenden Ansprüche und ein Uhrengehäuse (BM), wobei das Führungselement (GD1) zwischen einem Paar Hörner (CN1, CN2) des Uhrengehäuses (BM) angeordnet und an ihm befestigt ist.

10. Zeitmessgerät nach dem vorhergehenden Anspruch, wobei die erste Zone (ZN1) eine ungleichmäßige Oberfläche aufweist.

11. Zeitmessgerät nach dem vorhergehenden Anspruch, wobei die erste Zone (ZN1) sandgestrahlt oder strukturiert ist.

12. Zeitmessgerät nach Anspruch 9, wobei die erste Zone (ZN1) eine Fresnel-Linse hat.

## Claims

1. Electronic strap (BR) for a timepiece, comprising:
- a printed circuit board (FL)
- an insert (IS) disposed on the printed circuit board (FL), comprising a guide element (EG1) provided to be placed between and fixed to a pair of horns (CN1, CN2) of a watch case (BM), the guide element (EG1) comprising a lightwave guide (GO) comprising:
• an input (EN) disposed on an interface between the guide element (GD1) and the printed circuit board (FL)
• a first output (SO1) disposed so as to be opposite a first zone (ZN1) of the watch case (BM) between the two horns (CN1, CN2) when the guide element (GD1) is placed between and fixed to the pair of horns (CN1, CN2)
• a first portion (PO1) connecting the input (EN) to the first output (SO1)
- a lightwave emitter (EM) installed on the printed circuit board (FL), at the level of the input (EN) of the wave guide (GO).

2. Strap (BR) according to the preceding claim, the waveguide (GO) comprising a second output (SO2) disposed so as to be opposite a second zone (ZN2) of the watch case between the two horns (CN1, CN2) when the guide element (GD1) is placed between and fixed to the pair of horns (CN1, CN2) and comprising a second portion (PO2) connecting the input (EN) to the second output (SO2).

3. Strap (BR) according to the preceding claim, the first output (SO1) and the second output (SO2) being disposed so that the first zone (ZN1) is situated on the side of one of the horns (CN1), and so that the second zone (ZN2) is situated on the side of the other of the horns (CN2).

4. Strap (BR) according to any of the preceding claims, the lightwave emitter (EM) comprising at least two wave sources of different frequencies.

5. Strap (BR) according to any of the preceding claims, the lightwave guide (GO) being transparent.

6. Strap (BR) according to any of the preceding claims, the printed circuit board (FL) comprising a first lateral portion (PL1) and an assembly of components, including an energy source (SE) and a microcontroller (MC), the assembly of components being mounted on the first lateral portion (PL1), the lightwave emitter (EM) being connected electrically to the assembly of components.

7. Strap (BR) according to the preceding claim, the assembly of components comprising at least one push button (BP).

8. Strap (BR) according to any of the preceding claims, the assembly of components comprising means of communication with another electronic object via a wireless communication system of the Bluetooth, WiFi or NFC type.

9. Timepiece comprising a strap (BR) according to any of the preceding claims and a watch case (BM), the guide element (GD1) being placed between and fixed to a pair of horns (CN1, CN2) of the watch case (BM).

10. Timepiece according to the preceding claim, the first zone (ZN1) having an irregular surface.

11. Timepiece according to the preceding claim, the first zone (ZN1) being sandblasted or structured.

12. Timepiece according to claim 9, the first zone (ZN1) having a Fresnel lens appearance.
